# EUROPÄISCHE PATENTANMELDUNG

(11) **EP 4 300 554 A1**
(43) Veröffentlichungstag der Anmeldung: **03.01.2024**
(21) Anmeldenummer: 22181749.7
(22) Anmeldetag: 29.06.2022
(51) Int. Cl.: H01L 21/60, H01L 23/48, H01L 25/07

(54) **VERFAHREN ZUR HERSTELLUNG EINER HALBLEITERANORDNUNG MIT EINEM HALBLEITERELEMENT UND EINEM SUBSTRAT**

(71) Anmelder: Siemens Aktiengesellschaft, 80333 München (DE)
(72) Erfinder: Schmenger, Jens, 91301 Forchheim (DE)
(74) Vertreter: Siemens Patent Attorneys

(57) **Zusammenfassung**

Die Erfindung betrifft ein Verfahren zur Herstellung einer Halbleiteranordnung (2) mit einem Halbleiterelement (4) und einem Substrat (12). Um eine Zuverlässigkeit der Halbleiteranordnung (2) zu verbessern, werden folgende Schritte vorgeschlagen: Stoffschlüssiges Verbinden (A) eines ersten Lastkontakts (6) des Halbleiterelements (4) mit einer ersten Metallisierung (10) des Substrats (12), Kontaktieren (B) eines profilierten Kontaktierungselements (22) mit einem zweiten Lastkontakt (8) des Halbleiterelements (4), welcher auf einer dem Substrat (12) abgewandten Seite des Halbleiterelements (4) angeordnet ist, wobei mittels der Profilierung (26) eine Vielzahl von Kontaktstellen (28) ausgebildet werden, Anpressen (C) des profilierten Kontaktierungselements (22) über einen Gehäusedeckel (30) an das Halbleiterelement (4).

## Beschreibung

Die Erfindung betrifft ein Verfahren zur Herstellung einer Halbleiteranordnung mit einem Halbleiterelement und einem Substrat.

Ferner betrifft die Erfindung eine Halbleiteranordnung mit einem Halbleiterelement und einem Substrat.

Darüber hinaus betrifft die Erfindung einen Stromrichter mit mindestens einer derartigen Halbleiteranordnung.

Eine derartige Halbleitermodulanordnung kommt in der Regel in einem Stromrichter zum Einsatz. Unter einem Stromrichter ist beispielsweise ein Gleichrichter, ein Wechselrichter, ein Umrichter oder ein Gleichspannungswandler zu verstehen. Die in der Halbleitermodulanordnung zum Einsatz kommenden Halbleiterelemente sind unter anderem Transistoren, Dioden, Triacs oder Thyristoren. Die Transistoren sind beispielsweise als Insulated-Gate-Bipolar-Transistoren (IGBTs), Feldeffekttransistoren oder Bipolartransistoren ausgeführt. Derartige Transistoren können einen Steuerkontakt und Lastkontakte umfassen. Üblicherweise werden Halbleiterelemente über Bonddrähte, welche insbesondere Aluminium enthalten, kontaktiert.

Die Offenlegungsschrift EP 3 958 306 A1 beschreibt ein Leistungsmodul mit mindestens zwei auf einem Substrat kontaktierten Leistungshalbleiteranordnungen, welche in einem Gehäuse angeordnet sind. Um die Zuverlässigkeit des Leistungsmoduls zu verbessern, wird vorgeschlagen, dass die Leistungshalbleiteranordnungen jeweils mindestens ein Halbleiterbauelement aufweisen, wobei das Gehäuse auf gegenüberliegenden Seiten Leistungsanschlüsse aufweist, wobei das Substrat Zuleitungen von den Leistungsanschlüssen zu den Leistungshalbleiteranordnungen aufweist, wobei die Zuleitungen derartig auf dem Substrat angeordnet sind, dass eine symmetrische Stromführung erfolgt.

Die Offenlegungsschrift WO 2022/002464 A1 beschreibt ein Leistungsmodul mit mindestens zwei Leistungseinheiten, welche jeweils mindestens einen Leistungshalbleiter und ein Substrat umfassen. Um den erforderlichen Bauraum des Leistungsmoduls zu verringern und eine Entwärmung zu verbessern, wird vorgeschlagen, dass der jeweils mindestens eine Leistungshalbleiter, insbesondere stoffschlüssig, mit dem jeweiligen Substrat verbunden ist, wobei die Substrate der mindestens zwei Leistungseinheiten jeweils unmittelbar stoffschlüssig mit einer Oberfläche eines gemeinsamen Kühlkörpers verbunden sind.

Die Patentschrift DE 20 2012 004 434 U1 beschreibt einen Metallformkörper zur Schaffung einer Verbindung eines Leistungshalbleiters mit oberseitigen Potentialflächen zu Dickdrähten oder Bändchen, wobei durch einen Metallformkörper, der eine oder mehrere Potentialflächen überragt und aus dem elektrisch vom übrigen Metallformkörper getrennt wenigstens ein Segment abgeteilt ist, das von einem Kontaktierungsabschnitt an eine Potentialfläche des Leistungshalbleiters zu einem davon lateral beabstandeten Befestigungsabschnitt für Dickdrähte reicht.

Insbesondere für bei konstanter Chipfläche immer größeren in den Chip eingeprägten Strömen kommen üblicherweise verwendete Bonddrähte, beispielsweise hinsichtlich der Lastwechselfestigkeit, an ihre Grenzen.

Vor diesem Hintergrund ist es eine Aufgabe der vorliegenden Erfindung, eine Halbleiteranordnung anzugeben, welche eine verbesserte Zuverlässigkeit aufweist.

Diese Aufgabe wird erfindungsgemäß gelöst durch ein Verfahren zur Herstellung einer Halbleiteranordnung mit einem Halbleiterelement und einem Substrat umfassend folgende Schritte: stoffschlüssiges Verbinden eines ersten Lastkontakts des Halbleiterelement mit einer ersten Metallisierung des Substrats, Kontaktieren eines profilierten Kontaktierungselements mit einem zweiten Lastkontakt des Halbleiterelements, welcher auf einer dem Substrat abgewandten Seite des Halbleiterelements angeordnet ist, wobei mittels der Profilierung eine Vielzahl von Kontaktstellen ausgebildet werden und das Anpressen des profilierten Kontaktierungselements über einen Gehäusedeckel an das Halbleiterelement erfolgt.

Ferner wird die Aufgabe erfindungsgemäß gelöst durch eine Halbleiteranordnung mit einem Halbleiterelement und einem Substrat, wobei das Halbleiterelement einen ersten Lastkontakt und einen zweiten Lastkontakt aufweist, wobei der erste Lastkontakt stoffschlüssig mit einer ersten Metallisierung des Substrats verbunden ist, wobei ein profiliertes Kontaktierungselement mit dem zweiten Lastkontakt, welcher auf einer dem Substrat abgewandten Seite des Halbleiterelements angeordnet ist, kontaktiert ist, wobei mittels der Profilierung eine Vielzahl von Kontaktstellen ausgebildet sind, wobei das profilierte Kontaktierungselement über einen Gehäusedeckel an das Halbleiterelement angepresst ist.

Darüber hinaus wird die Aufgabe erfindungsgemäß gelöst durch einen Stromrichter mit mindestens einer derartigen Halbleiteranordnung.

Die in Bezug auf die Halbleiteranordnung nachstehend angeführten Vorteile und bevorzugten Ausgestaltungen lassen sich sinngemäß auf den Stromrichter und das Verfahren übertragen.

Der Erfindung liegt die Überlegung zugrunde, die Lastwechselfestigkeit einer Halbleiteranordnung durch eine verbesserte Kontaktierung von Halbleiterelementen zu verbessern. Ein erster Lastkontakt des Halbleiterelements wird stoffschlüssig mit einer ersten Metallisierung eines Substrats verbunden. Die erste Metallisierung des Substrats kann strukturiert ausgeführt und auf einer dielektrischen Materiallage, welche unter anderem einen keramischen Werkstoff wie Aluminiumnitrid oder Aluminiumoxid oder einen organischen Werkstoff enthalten kann, angeordnet sein. Beispielsweise ist die erste Metallisierung als eine Kupferkaschierung ausgeführt. Die stoffschlüssige Verbindung des Halbleiterelements zur ersten Metallisierung kann unter anderem durch Löten, Sintern, aber auch durch eine adhäsive Verbindung, z.B. mit einem elektrisch und thermisch leitfähigen Kleber, hergestellt werden.

Daraufhin wird ein profiliertes Kontaktierungselement mit einem zweiten Lastkontakt, welcher, wie es z.B. bei einem vertikalen Leistungshalbleiter, insbesondere IGBT, üblich ist, auf einer dem Substrat abgewandten Seite des Halbleiterelements angeordnet ist, kontaktiert, wobei mittels der Profilierung eine Vielzahl von Kontaktstellen ausgebildet werden. Das Kontaktierungselement kann unter anderem als Blech, insbesondere Federblech, ausgeführt sein, welches im Bereich der Kontaktierung mit dem zweiten Lastkontakt alternierend periodisch profiliert sein kann. Eine alternierend periodische Profilierung kann unter anderem eine unendlich fortsetzbare Folge von miteinander verbundenen punktsymmetrischen Einzelprofilierungen umfassen. Eine alternierend periodische Profilierung ist beispielsweise eine im Wesentlichen sinusförmige Wellenform. Das Kontaktierungselement kann beispielsweise konfiguriert sein, um mit der ersten Metallisierung des Substrats kontaktiert oder an einen externen Anschluss geführt werden.

In einem weiteren Schritt wird das profilierte Kontaktierungselement an das Halbleiterelement über einen Gehäusedeckel angepresst. Beispielsweise übt ein aus einem dielektrischen Werkstoff, insbesondere einem Polymer, hergestellter Gehäusedeckel eine orthogonal zum zweiten Lastkontakt wirkende Kraft auf die Profilierung des Kontaktierungselements aus. Durch die Belastung des Kontaktierungselements mit Druck wird dieses, insbesondere elastisch, verformt. Derartige Kontaktierungselemente weisen eine hohe Stromtragfähigkeit auf und verbessern insbesondere die Lastwechselfestigkeit der Halbleiteranordnung. Dies führt zu einer verbesserten Zuverlässigkeit. Darüber hinaus bleibt, insbesondere im Vergleich zu einem Standard-Bondverfahren, eine Architektur der Halbleiteranordnung weitestgehend erhalten und ein derartiges Herstellungsverfahren ist einfach und kostengünstig in einen Standard-Serienherstellungsprozess integrierbar.

Eine weitere Ausführungsform sieht folgende Schritte vor: Stoffschlüssiges Verbinden eines Metallformkörpers mit dem zweiten Lastkontakt des Halbleiterelements vor dem Kontaktieren des profilierten Kontaktierungselements, Kontaktieren des profilierten Kontaktierungselements mit dem zweiten Lastkontakt des Halbleiterelements über den Metallformkörper. Der Metallformkörper kann als ein Blech, welches unter anderem Kupfer, Aluminium, Silber, Gold, Molybdän oder eine deren Legierungen enthalten kann, ausgeführt sein. Die stoffschlüssige Verbindung des Halbleiterelements zum Metallformkörper kann unter anderem durch Löten, Sintern, aber auch durch eine adhäsive Verbindung, z.B. mit einem elektrisch und thermisch leitfähigen Kleber, hergestellt werden. Alternativ kann der Metallformkörper mittels eines additiven Verfahrens, insbesondere mittels eines thermischen Spritzverfahrens wie Kaltgasspritzen, auf dem zweiten Lastkontakt des Halbleiterelements aufgebracht und auf diese Weise stoffschlüssig mit dem zweiten Lastkontakt des Halbleiterelements verbunden sein. Durch den Metallformkörper wird ein durch die Vielzahl von Kontaktstellen hergestellter Druck auf das Halbleiterelement verteilt. Dies sorgt, insbesondere bei im Betrieb auftretenden mechanischen oder thermischen Belastungsschwankungen, für eine gleichmäßigere Druckverteilung, sodass beispielsweise ein Brechen des Halbleiterelements verhindert wird. Somit wird durch den Metallformkörper die Zuverlässigkeit der Halbleiteranordnung verbessert.

Eine weitere Ausführungsform sieht vor, dass nach dem Anpressen ein Vergießen der Halbleiteranordnung erfolgt. Durch eine Vergussmasse, welcher z.B. Silikon enthält, werden erforderliche Spannungsabstände eingehalten. Ferner dient ein derartiger Verguss zum Schutz vor schädlichen Umwelteinflüssen.

Eine weitere Ausführungsform sieht vor, dass das Kontaktieren des profilierten Kontaktierungselements unmittelbar auf dem Metallformkörper erfolgt. Eine unmittelbare Kontaktierung erfolgt ohne weitere Verbindungsmittel wie Lötzinn oder Kleber. Eine derartige Kontaktierung ist, insbesondere in Kombination mit dem Anpressen, einfach und zuverlässig.

Eine weitere Ausführungsform sieht vor, dass das profilierte Kontaktierungselement beim Anpressen vorwiegend elastisch verformt wird. Beispielsweise enthält das profilierte Kontaktierungselement eine elastische Kupferlegierung wie CuZn37, CuSn6, CuNi18Zn20, Kupfer-Beryllium oder einen Federstahl. Durch eine vorwiegend elastische Verformung wird ein ausreichender Anpressdruck auch bei Lastwechseln und Temperaturschwankungen gewährleitet, sodass eine verbesserte Zuverlässigkeit erreicht wird. Ferner können Höhenunterschiede zwischen Halbleiterelement und Substrat sowie ggf. ein Verkippen des Halbleiterelements ausgeglichen werden, was sich ebenfalls positiv auf die Zuverlässigkeit der Halbleiteranordnung auswirkt.

Eine weitere Ausführungsform sieht vor, dass mittels einer S-förmig oder trapezförmig ausgeführten Profilierung des profilierten Kontaktierungselements eine Vielzahl von Kontaktstellen ausgebildet wird. Derartige Profilierungen sind einfach und kostengünstig herstellbar. Ferner werden durch derartige Profilierungen eine homogene Kraft- und Wärmeverteilung sowie eine Wärmespreizung auf der Chipoberfläche erreicht.

Eine weitere Ausführungsform sieht vor, dass das profilierte Kontaktierungselement zur Verbindung des zweiten Lastkontakts, insbesondere stoffschlüssig, mit einer ersten Metallisierung des Substrats verbunden wird. Die stoffschlüssige Verbindung kann, unter anderem, durch Löten, Sintern, aber auch durch Adhäsion, z.B. mit einem elektrisch und thermisch leitfähigen Kleber, hergestellt werden. Eine derartige Anordnung ist einfach und kostengünstig realisierbar.

Eine weitere Ausführungsform sieht vor, dass das profilierten Kontaktierungselement zur Verbindung des zweiten Lastkontakts über den Gehäusedeckel auf die erste Metallisierung des Substrats gepresst wird. Durch eine derartige Verbindung wird, insbesondere bei häufigen Lastwechseln und Temperaturschwankungen, eine verbesserte Zuverlässigkeit erreicht.

Im Folgenden wird die Erfindung anhand der in den Figuren dargestellten Ausführungsbeispiele näher beschrieben und erläutert.

Es zeigen:
- FIG 1: eine schematische Querschnittsdarstellung einer ersten Ausführungsform einer Halbleiteranordnung,
- FIG 2: ein Ablaufdiagramm eines Verfahrens zur Herstellung einer Halbleiteranordnung,
- FIG 3: eine schematische Querschnittsdarstellung einer zweiten Ausführungsform einer Halbleiteranordnung,
- FIG 4: eine schematische Querschnittsdarstellung einer dritten Ausführungsform einer Halbleiteranordnung,
- FIG 5: eine schematische perspektivische Darstellung einer vierten Ausführungsform einer Halbleiteranordnung,
- FIG 6: eine schematische Darstellung eines Stromrichters.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

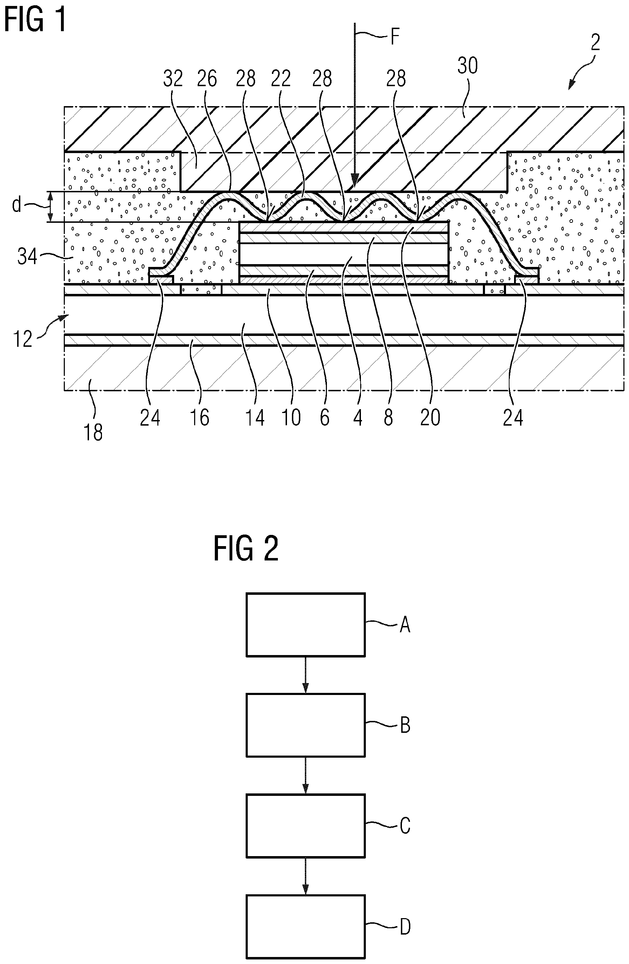

FIG 1 zeigt eine schematische Querschnittsdarstellung einer ersten Ausführungsform einer Halbleiteranordnung 2, welche ein Halbleiterelement 4 umfasst, das als vertikaler Leistungstransistor, insbesondere als Insulated-Gate-BipolarTransistor (IGBT), ausgeführt ist. Weitere Beispiele für derartige Halbleiterelemente 4 sind Triacs, Thyristoren, Dioden oder andere Transistortypen wie Feldeffekttransistoren und Bipolartransistoren. Das Halbleiterelement 4 weist einen ersten Lastkontakt 6 und einen zweiten Lastkontakt 8 auf, ein Steuerkontakt ist aus Gründen der Übersichtlichkeit in FIG 1 nicht dargestellt.

Der erste Lastkontakt 6 des Halbleiterelements 4 ist stoffschlüssig mit einer strukturierten ersten Metallisierung 10 eines Substrats 12 verbunden. Die stoffschlüssige Verbindung des Halbleiterelements 4 mit dem Substrat 12 kann unter anderem durch eine Lötverbindung und/oder eine Sinterverbindung, aber auch durch eine adhäsive Verbindung, z.B. mit einem elektrisch und thermisch leitfähigen Kleber, hergestellt sein. Das Substrat 12 weist darüber hinaus eine dielektrische Materiallage 14 und eine auf einer der ersten Metallisierung 10 abgewandten Seite des Substrats 12 angeordnete zweite Metallisierung 16 auf. Die dielektrische Materiallage 14 kann unter anderem einen keramischen Werkstoff, insbesondere Aluminiumnitrid oder Aluminiumoxid, oder einen organischen Werkstoff enthalten. Ferner ist das Substrat 12 über die zweite Metallisierung 16, insbesondere stoffschlüssig, mit einem Kühlkörper 18 verbunden, sodass das Halbleiterelement 4 über das Substrat mit dem Kühlkörper 18 in einer elektrisch isolierenden und thermisch leitfähigen Verbindung steht.

Der zweite Lastkontakts 8 des Halbleiterelements 4, welcher auf einer dem Substrat 12 abgewandten Seite des Halbleiterelements 4 angeordnet ist, ist stoffschlüssig mit einem Metallformkörper 20 verbunden, welcher als eine Bufferschicht fungiert. Beispielsweise ist der Metallformkörper 20 als ein Blech, insbesondere als ein Kupferblech, ausgeführt, welches über eine Sinterverbindung mit der Steuerkontakt-Kontaktfläche verbunden ist. Ferner kann das Blech eine einseitige und/oder beidseitige Beschichtung, beispielsweise zur Herstellung einer Bondverbindung, aufweisen. Eine derartige Beschichtung kann unter anderem Aluminium, Silber, Gold, Zink oder eine deren Legierungen enthalten. Alternativ kann der Metallformkörper 20 mittels eines additiven Verfahrens, insbesondere mittels eines thermischen Spritzverfahrens wie Kaltgasspritzen, aufgebracht sein.

Ferner ist ein profiliertes Kontaktierungselement 22, welches aus einem metallischen Werkstoff hergestellt ist, über den Metallformkörper 20 unmittelbar, das heißt ohne weitere Verbindungsmittel, mit dem zweiten Lastkontakt 8 kontaktiert. Das profilierte Kontaktierungselement 22 ist beispielhaft beidseitig an der ersten Metallisierung 10 des Substrats 12 über eine stoffschlüssige Verbindung 24 befestigt. Die stoffschlüssige Verbindung 24 kann unter anderem über Sintern, Löten oder ein Schweißverfahren hergestellt werden. Darüber hinaus weist das Kontaktierungselement 22 im Bereich der Kontaktierung mit dem zweiten Lastkontakt 8 eine S-förmige Profilierung 26 auf, welche vorwiegend elastisch verformbar ist. Beispielsweise enthält das profilierte Kontaktierungselement 22 eine elastische Kupferlegierung wie CuZn37, CuSn6, CuNi18Zn20, Kupfer-Beryllium oder einen Federstahl. Das Mittels der S-förmigen Profilierung 26 wird eine Vielzahl von im Wesentlichen linienförmigen Kontaktstellen 28 zum Lastkontakt 8 ausgebildet. Insbesondere ist Kontaktierungselement 22 als Federblech ausgeführt, welches im Bereich der Kontaktierung mit dem zweiten Lastkontakt 8 wellenförmig profiliert ist.

Über einen Gehäusedeckel 30, welcher aus einem dielektrischen Werkstoff, beispielsweise einem Polymer, hergestellt ist, wirkt eine Kraft F auf die S-förmige Profilierung 26 des Kontaktierungselements 22. Insbesondere ist die Kraft F orthogonal zum zweiten Lastkontakt 8 wirkend gerichtet. Im Vergleich zum profilierten Kontaktierungselement 22 verformt sich der Gehäusedeckel 30 nicht merklich. Somit wird das profilierte Kontaktierungselement 22 durch den Gehäusedeckel 30 an das Halbleiterelement 4 angepresst. Um durch den Gehäusedeckel 30 eine definierte Kraft F auf das Kontaktierungselement 22 auszuüben, wird über dem Halbleiterelement 4 ein definierter Abstand d hergestellt. Die Herstellung des definierter Abstands d zum Halbleiterelement 4 wird in FIG 1 beispielhaft durch einen Vorsprung 32 realisiert. Alternativ kann der Gehäusedeckel 30 zweiteilig mit einem, insbesondere quaderförmigen, Druckelement ausgeführt sein oder, abhängig von der Profilierung 26 des Kontaktierungselements 22, eine Aussparung aufweisen. Überdies ist die Halbleiteranordnung 2 zwischen Gehäusedeckel 30 und Substrat 12 mittels einer Vergussmasse 34, welcher z.B. Silikon enthält und zur Einhaltung der erforderlichen Spannungsabstände und zum Schutz vor schädlichen Umwelteinflüssen dient, vergossen.

FIG 2 zeigt ein Ablaufdiagramm eines Verfahrens zur Herstellung einer Halbleiteranordnung 2, welche beispielsweise wie in FIG 1 dargestellt ausgeführt ist, mit einem Halbleiterelement 4 und einem Substrat 12. Das Verfahren umfasst ein stoffschlüssiges Verbinden A eines ersten Lastkontakts 6 des Halbleiterelements 4 mit einer ersten Metallisierung 10 des Substrats 12 und eines zweiten Lastkontakts 8 des Halbleiterelements 4, welcher auf einer dem Substrat 12 abgewandten Seite des Halbleiterelements 4 angeordnet ist, mit einem Metallformkörper 20.

In einem weiteren Schritt erfolgt ein Kontaktieren B eines profilierten Kontaktierungselements 22 über den Metallformkörper 20 mit dem zweiten Lastkontakt 8, wobei mittels der Profilierung 26 eine Vielzahl von Kontaktstellen 28 ausgebildet werden. Das Kontaktieren B des profilierten Kontaktierungselements 22 erfolgt unmittelbar auf dem Metallformkörper 20.

Ein Anpressen C des profilierten Kontaktierungselements 22 an das Halbleiterelement 4 über einen Gehäusedeckel 30 erfolgt in einem weiteren Schritt, wobei das profilierte Kontaktierungselement 22 beim Anpressen C vorwiegend elastisch verformt wird. Nach dem Anpressen C erfolgt ein Vergießen D der Halbleiteranordnung 4 mittels einer Vergussmasse 34.

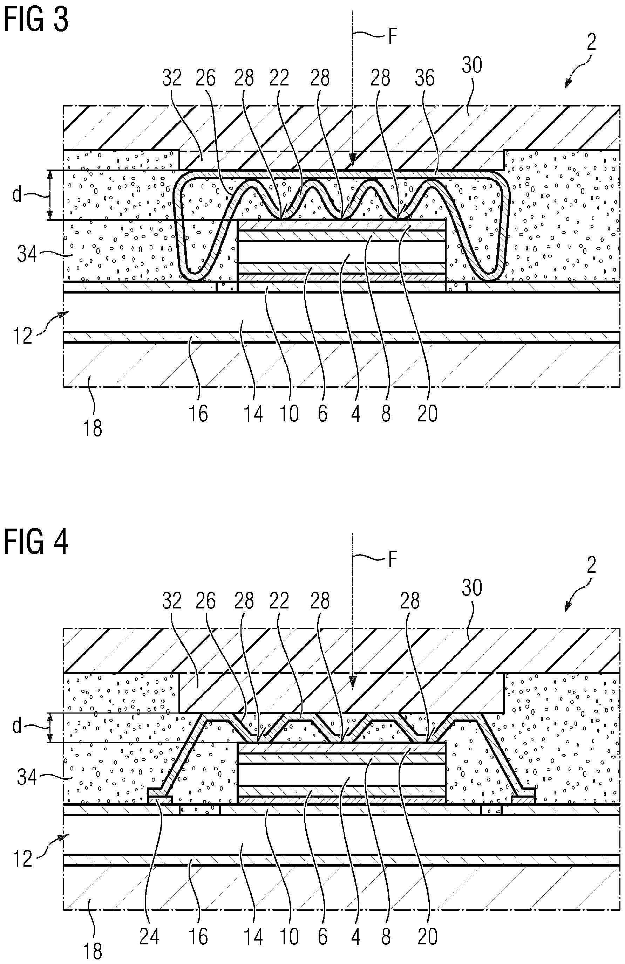

FIG 3 zeigt eine schematische Querschnittsdarstellung einer zweiten Ausführungsform einer Halbleiteranordnung 2. Das profilierte Kontaktierungselement 22 ist als ein im Querschnitt geschlossen ausgeführtes Federblech ausgeführt, welches eine S-förmige Profilierung 26 und, parallel dazu verlaufend, einen geraden Abschnitt 36 aufweist, wobei der gerade Abschnitt 36 unmittelbar flächig mit dem Vorsprung 32 des Gehäusedeckels 32 kontaktiert ist. Durch den Vorsprung 32 des Gehäusedeckels 32 wird die S-förmige Profilierung 26 des Kontaktierungselements 22 auf den Metallformkörper 20 sowie beidseitig auf die erste Metallisierung 10 des Substrats 12 gepresst. Auf diese Weise wird der zweite Lastkontakt 8 des Halbleiterelements 4 ohne eine stoffschlüssige Verbindung und ohne Verbindungsmittel wie Lötzinn, Sinterpaste oder Klebstoff mit der ersten Metallisierung 10 des Substrats 12 kontaktiert. Die weitere Ausführung der Halbleiteranordnung 2 in FIG 3 entspricht der in FIG 1.

FIG 4 zeigt eine schematische Querschnittsdarstellung einer dritten Ausführungsform einer Halbleiteranordnung 2, wobei das Kontaktierungselement 22 im Bereich der Kontaktierung mit dem zweiten Lastkontakt 8 eine trapezförmig ausgeführte Profilierung 26 aufweist. Die weitere Ausführung der Halbleiteranordnung 2 in FIG 4 entspricht der in FIG 1.

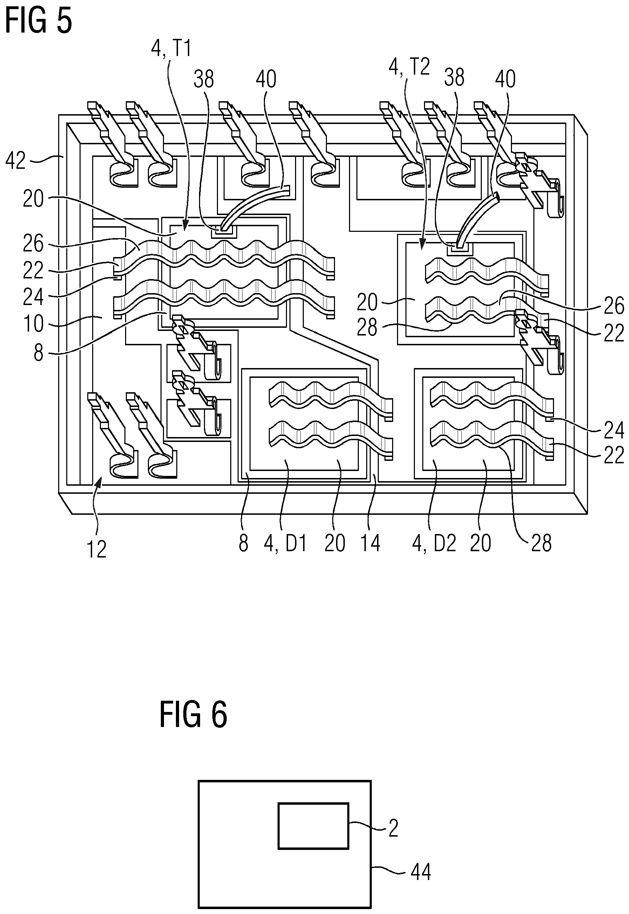

FIG 5 zeigt eine schematische perspektivische Darstellung einer vierten Ausführungsform einer Halbleiteranordnung 2, welche Halbleiterelemente 4 umfasst, die als Transistoren T1, T2 und Dioden D1, D2 ausgeführt sind. Die Transistoren T1, T2, welche beispielhaft als IGBTs ausgeführt sind, weisen jeweils einen Steuerkontakt 38 auf, welcher über jeweils einen Bonddraht 40 mit der ersten Metallisierung 10 des Substrats 12 verbunden ist. Ein Gehäuserahmen 42 umgibt das Substrat 12 vollständig. Eine Vergussmasse, welche durch den Gehäuserahmen 42 begrenzt wird, sowie ein Gehäusedeckel, welcher die profilierten Kontaktierungselemente 22 auf die jeweiligen Metallformkörper 20 der Halbleiterelemente 4, sind aus Gründen der Übersichtlichkeit in FIG 5 nicht dargestellt. Der Gehäusedeckel wird mittels Schrauben am Gehäuserahmen 42 befestigt. Die weitere Ausführung der Halbleiteranordnung 2 in FIG 5 entspricht der in FIG 1.

FIG 6 zeigt eine schematische Darstellung eines Stromrichters 44, welcher beispielhaft eine Halbleiteranordnung 2 umfasst.

Zusammenfassend betrifft die Erfindung ein Verfahren zur Herstellung einer Halbleiteranordnung 2 mit einem Halbleiterelement 4 und einem Substrat 12. Um eine Zuverlässigkeit der Halbleiteranordnung 2 zu verbessern, werden folgende Schritte vorgeschlagen: Stoffschlüssiges Verbinden A eines ersten Lastkontakts 6 des Halbleiterelements 4 mit einer ersten Metallisierung 10 des Substrats 12, Kontaktieren B eines profilierten Kontaktierungselements 22 mit einem zweiten Lastkontakt 8 des Halbleiterelements 4, welcher auf einer dem Substrat 12 abgewandten Seite des Halbleiterelements 4 angeordnet ist, wobei mittels der Profilierung 26 eine Vielzahl von Kontaktstellen 28 ausgebildet werden, Anpressen C des profilierten Kontaktierungselements 22 über einen Gehäusedeckel 30 an das Halbleiterelement 4.

## Patentansprüche

1. Verfahren zur Herstellung einer Halbleiteranordnung (2) mit einem Halbleiterelement (4) und einem Substrat (12), umfassend folgende Schritte:
- stoffschlüssiges Verbinden (A) eines ersten Lastkontakts (6) des Halbleiterelements (4) mit einer ersten Metallisierung (10) des Substrats (12),
- Kontaktieren (B) eines profilierten Kontaktierungselements (22) mit einem zweiten Lastkontakt (8) des Halbleiterelements (4),
welcher auf einer dem Substrat (12) abgewandten Seite des Halbleiterelements (4) angeordnet ist,
wobei mittels der Profilierung (26) eine Vielzahl von Kontaktstellen (28) ausgebildet werden,
- Anpressen (C) des profilierten Kontaktierungselements (22) über einen Gehäusedeckel (30) an das Halbleiterelement (4) .

2. Verfahren nach Anspruch 1,
umfassend folgende Schritte:
- stoffschlüssiges Verbinden (A) eines Metallformkörpers (20) mit dem zweiten Lastkontakt (8) des Halbleiterelements (4) vor dem Kontaktieren (B) des profilierten Kontaktierungselements (22),
- Kontaktieren (B) des profilierten Kontaktierungselements (22) mit dem zweiten Lastkontakt (8) des Halbleiterelements (4) über den Metallformkörper (20).

3. Verfahren nach einem der Ansprüche 1 oder 2,
wobei nach dem Anpressen (C) ein Vergießen (D) der Halbleiteranordnung (4) erfolgt.

4. Verfahren nach einem der vorherigen Ansprüche,
wobei das Kontaktieren (B) des profilierten Kontaktierungselements (22) unmittelbar auf dem Metallformkörper (20) erfolgt.

5. Verfahren nach einem der vorherigen Ansprüche,
wobei das profilierte Kontaktierungselement (22) beim Anpressen (C) vorwiegend elastisch verformt wird.

6. Verfahren nach einem der vorherigen Ansprüche,
wobei mittels einer S-förmig oder trapezförmig ausgeführten Profilierung (26) des profilierten Kontaktierungselements (22) die Vielzahl von Kontaktstellen (28) ausgebildet wird.

7. Verfahren nach einem der vorherigen Ansprüche,
wobei das profilierte Kontaktierungselement (22) zur Verbindung des zweiten Lastkontakts (8), insbesondere stoffschlüssig, mit der ersten Metallisierung (10) des Substrats (12) verbunden wird.

8. Verfahren nach einem der Ansprüche 1 bis 6,
wobei das profilierte Kontaktierungselement (22) zur Verbindung des zweiten Lastkontakts (8) über den Gehäusedeckel (30) auf die erste Metallisierung (10) des Substrats (12) gepresst wird.

9. Halbleiteranordnung (2) mit einem Halbleiterelement (4) und einem Substrat (12),
wobei das Halbleiterelement (4) einen ersten Lastkontakt (6) und einen zweiten Lastkontakt (8) aufweist,
wobei der erste Lastkontakt (6) stoffschlüssig mit einer ersten Metallisierung (10) des Substrats (12) verbunden ist, wobei ein profiliertes Kontaktierungselement (22) mit dem zweiten Lastkontakt (8), welcher auf einer dem Substrat (12) abgewandten Seite des Halbleiterelements (4) angeordnet ist, kontaktiert ist,
wobei mittels der Profilierung (26) eine Vielzahl von Kontaktstellen (28) ausgebildet sind,
wobei das profilierte Kontaktierungselement (22) über einen Gehäusedeckel (30) an das Halbleiterelement (4) angepresst ist.

10. Halbleiteranordnung (2) nach Anspruch 9,
wobei ein Metallformkörper (20) stoffschlüssig mit dem zweiten Lastkontakt (8) verbunden ist,
wobei das profilierte Kontaktierungselement (22) über den Metallformkörper (20) mit dem zweiten Lastkontakt (8) kontaktiert ist.

11. Halbleiteranordnung (2) nach einem der Ansprüche 9 oder 10,
welche mittels einer Vergussmasse (34) vergossen ist.

12. Halbleiteranordnung (2) nach einem der Ansprüche 9 bis 11,
wobei das profilierte Kontaktierungselement (22) unmittelbar auf dem Metallformkörper (20) kontaktiert ist.

13. Halbleiteranordnung (2) nach einem der Ansprüche 9 bis 12,
wobei das profilierte Kontaktierungselement (22) durch das Anpressen (C) vorwiegend elastisch verformt ist.

14. Halbleiteranordnung (2) nach einem der Ansprüche 9 bis 13,
wobei das profilierte Kontaktierungselement (22) als Federblech ausgeführt ist.

15. Halbleiteranordnung (2) nach einem der Ansprüche 9 bis 14,
wobei die Profilierung (26) des das profilierten Kontaktierungselements (22) zumindest teilweise S-förmig oder trapezförmig ausgeführt ist.

16. Halbleiteranordnung (2) nach einem der Ansprüche 9 bis 15,
wobei das profilierte Kontaktierungselement (22) zur Verbindung des zweiten Lastkontakts (8), insbesondere stoffschlüssig, mit der ersten Metallisierung (10) des Substrats (12) verbunden ist.

17. Halbleiteranordnung (2) nach einem der Ansprüche 9 bis 15,
wobei das profilierte Kontaktierungselement (22) zur Verbindung des zweiten Lastkontakts (8) über den Gehäusedeckel (30) auf die erste Metallisierung (10) des Substrats (12) gepresst ist.

18. Stromrichter (44) mit mindestens einer Halbleiteranordnung (2) nach einem der Ansprüche 9 bis 17.
